# EUROPEAN PATENT APPLICATION

(11) **EP 4 766 112 A1**
(43) Date of publication of application: **24.06.2026**
(21) Application number: 24939050.1
(22) Date of filing: 29.08.2024
(51) Int. Cl.: H10K 50/13

(54) **DISPLAY PANEL AND DISPLAY DEVICE**

(30) Priority: 23.08.2024 CN 202411167793
(71) Applicant: Wuhan China Star Optoelectronics Semiconductor Display Technology Co., Ltd., Wuhan, Hubei 430079 (CN)
(72) Inventor: LI, Lintao, Wuhan, Hubei 430079 (CN); WU, Kailong, Wuhan, Hubei 430079 (CN); ZHAO, Juewen, Wuhan, Hubei 430079 (CN); TAN, Yue, Wuhan, Hubei 430079 (CN)
(74) Representative: Zhu, Puxing
(86) International application number: PCT/CN2024/115591
(87) International publication number: WO 2026/040121

(57) **Abstract**

A display panel and a display device are provided. An orthographic projection of a first blue light emitting unit on a substrate overlaps with an orthographic projection of a first electron-blocking unit on the substrate. An orthographic projection of a first green light emitting unit on the substrate overlaps with an orthographic projection of a second electron-blocking unit on the substrate. A ratio of a thickness of the second electron-blocking unit to a thickness of the first electron-blocking unit is a first ratio, and the first ratio is less than 2.

## Description

### TECHNICAL FIELD

The present application relates to the field of display technologies, and in particular, to a display panel and a display device.

### BACKGROUND

With the development of flat display technologies, customers' requirements for the stability of displays are gradually increasing. In recent years, organic light emitting diode (OLED) displays have developed rapidly worldwide, and OLED display technologies have also become increasingly advanced. Under the worldwide environment, application demands for stacked OLED devices have increased, major display manufacturers have also invested resources in technology and product development, and various structures of stacked devices are launched. At present, mainstream stacked OLED devices have complex structures and high manufacturing costs. It is critical to reduce the costs of stacked OLED devices.

### TECHNICAL PROBLEMS

This application provides a display panel and a display device that are beneficial in reducing the manufacturing costs of the display panel.

### TECHNICAL SOLUTIONS

According to a first aspect, a display panel is provided in this application. The display panel includes a substrate and a light emitting device layer. The light emitting device layer is arranged on a side of the substrate. The light emitting device layer includes an anode layer, a first electron-blocking layer, a first light emitting layer, a charge generation layer, a second light emitting layer, and a cathode layer. The anode layer is arranged on a side of the substrate. The first electron-blocking layer is arranged on a side, away from the substrate, of the anode layer and includes a first electron-blocking unit and a second electron-blocking unit. A first ratio is a thickness of the second electron-blocking unit divided by a thickness of the first electron-blocking unit, and the first ratio is less than 2. The first light emitting layer is arranged on a side, away from the anode layer, of the first electron-blocking layer and includes a first blue light emitting unit and a first green light emitting unit. An orthographic projection of the first blue light emitting unit on the substrate overlaps with an orthographic projection of the first electron-blocking unit on the substrate. An orthographic projection of the first green light emitting unit on the substrate overlaps with the orthographic projection of the second electron-blocking unit on the substrate. The charge generation layer is arranged on a side, away from the first electron-blocking layer, of the first light emitting layer. The second light emitting layer is arranged on a side, away from the first light emitting layer, of the charge generation layer. The cathode layer is arranged on a side, away from the charge generation layer, of the second light emitting layer.

According to a second aspect, the present application also provides a display device including the aforementioned display panel.

### ADVANTAGES

In the display panel and the display device according to some embodiments of the present application, an orthographic projection of a first blue light emitting unit on a substrate overlaps with an orthographic projection of a first electron-blocking unit on the substrate. An orthographic projection of a first green light emitting unit on the substrate overlaps with an orthographic projection of the second electron-blocking unit on the substrate. A ratio of a thickness of the second electron-blocking unit to a thickness of the first electron-blocking unit is a first ratio, and the first ratio is less than 2. In this way, a thickness, overlapping with the first green light emitting unit, of the second electron-blocking unit is relatively thinner, which is beneficial in reducing a rate of evaporation and deposition of a material forming the second electron-blocking unit, so that a material of the second electron-blocking unit and a material of the first green light emitting unit are placed in one chamber for evaporation and deposition and share one mask for the evaporation and deposition, thereby reducing the manufacturing costs of the display panel and the display device.

### BRIEF DESCRIPTION OF THE DRAWINGS

FIG. 1 is a schematic diagram of a cross-sectional structure of a display panel according to some embodiments of the present application;
FIG. 2 is a schematic diagram of a cross-sectional structure of a display panel according to other embodiments of the present application;
FIG. 3 is a schematic diagram of a cross-sectional structure of a display panel according to yet another embodiments of the present application;
FIG. 4 is a structural block diagram of a display device according to some embodiments of the present application.

The reference numerals are as follows:
100, display panel; 200, display device;
111, substrate; 112, driving circuit layer;
12, light emitting device layer;
13, anode layer;
14, first light emitting stack;
141, first electron-blocking layer; 1411, first electron-blocking unit; 1412, second electron-blocking unit; 1413, third electron-blocking unit;
142, first light emitting layer; 1421, first blue light emitting unit; 1422, first green light emitting unit; 1423, first red light emitting unit;
143, hole inject layer; 144, first hole transport layer; 145, first hole blocking layer; 146, first electron transport layer;
15, charge generation layer; 151, n-type charge generation layer; 152, p-type charge generation layer;
16, second light emitting stack;
161, second electron-blocking layer; 1611, fourth electron-blocking unit; 1612, fifth electron-blocking unit; 1613, sixth electron-blocking unit;
162, second light emitting layer; 1621, second blue light emitting unit; 1622, second green light emitting unit; 1623, second red light emitting unit;
163, second hole transport layer; 164, second hole blocking layer; 165, second electron transport layer; 166, electron inject layer;
17, cathode layer;
18, cover layer;
191, first intermediate transport layer; 192, second intermediate transport layer.

### DETAILED DESCRIPTION

The following will provide a clear and complete description of the technical solutions according to embodiments of the present application, in conjunction with the accompanying drawings. Obviously, the described embodiments are only a part of the embodiments of the present application, not all of them. Based on the embodiments in this application, all other embodiments obtained by those skilled in the art without paying creative efforts are within the protection scope of this application.

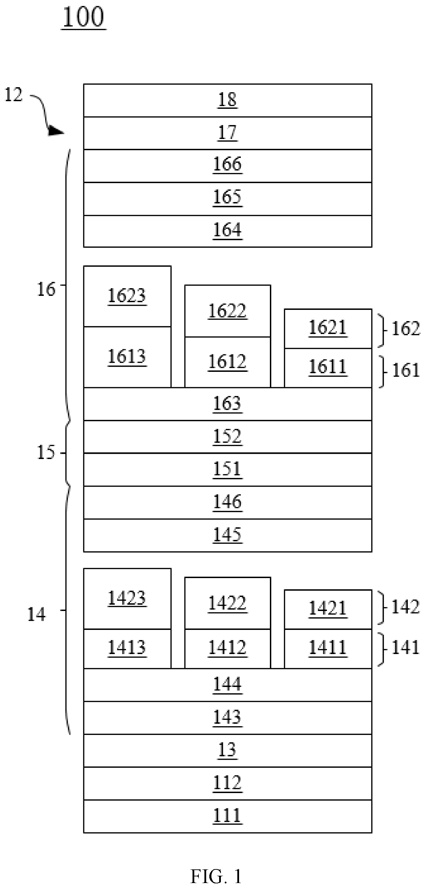

As shown in FIG. 1 to FIG. 3, the present application provides a display panel 100. The display panel 100 is an organic light emitting diode display panel. The display panel 100 includes a substrate 111 and a light emitting device layer 12. The light emitting device layer 12 is arranged on a side of the substrate 111. The light emitting device layer 12 includes an anode layer 13, a first light emitting stack 14, a charge generation layer 15, a second light emitting stack 16, and a cathode layer 17. The first light emitting stack 14 is a bottom light emitting stack, and the second light emitting stack 16 is a top light emitting stack. It can be understood that the light emitting device layer 12 may include three or more light emitting stacks, and the charge generation layer 15 is arranged between adjacent two light emitting stacks.

The anode layer 13 is arranged on a side of the substrate 111. The anode layer 13 may include a first transparent anode layer and a first reflective anode layer that are stacked with each other. The first transparent anode layer is arranged between the first reflective anode layer and the substrate 111. The anode layer 13 may also include a second transparent anode layer, which is arranged on a side, away from the first transparent anode layer, of the first reflective anode layer. The first transparent anode layer and the second transparent anode layer can be made of transparent conductive materials. The first reflective anode layer can be made of metal materials such as silver.

The first light emitting stack 14 includes a first electron-blocking layer 141 (EBL) and a first light emitting layer 142.

The first electron-blocking layer 141 plays a role in blocking electrons. The first electron-blocking layer 141 is arranged on a side, away from the substrate 111, of the anode layer 13. The first electron-blocking layer 141 includes a first electron-blocking unit 1411 and a second electron-blocking unit 1412.

The first light emitting layer 142 is arranged on a side, away from the anode layer 13, of the first electron-blocking layer 141. The first light emitting layer 142 includes a first blue light emitting unit 1421 and a first green light emitting unit 1422.

An orthographic projection of the first blue light emitting unit 1421 on the substrate 111 overlaps with an orthographic projection of the first electron-blocking unit 1411 on the substrate 111. That is, the first electron-blocking unit 1411 plays a role in blocking electrons in the first blue light emitting device of the first light emitting stack 14. The first blue light emitting unit 1421 and the first electron-blocking unit 1411 are stacked and in direct contact with each other.

An orthographic projection of the first green light emitting unit 1422 on the substrate 111 overlaps with an orthographic projection of the second electron-blocking unit 1412 on the substrate 111. That is, the second electron-blocking unit 1412 plays a role in blocking electrons in the first green light emitting device of the first light emitting stack 14. The first green light emitting unit 1422 and the second electron-blocking unit 1412 are stacked and in direct contact with each other.

A ratio of a thickness of the second electron-blocking unit 1412 to a thickness of the first electron-blocking unit 1411 is a first ratio, and the first ratio is less than 2. Therefore, the thickness, overlapping with the first green light emitting unit 1422, of the second electron-blocking unit 1412 is relatively thinner, which is beneficial in reducing a rate of evaporation and deposition of a material forming the second electron-blocking unit 1412. Moreover, after the evaporation and deposition of the second electron-blocking unit 1412 is completed, the evaporation and deposition process of the material forming the second electron-blocking unit 1412 has not stop yet, and thus a material for the evaporation and deposition accumulates on a barrier plate that closes a gate. A lower rate of the evaporation and deposition is sufficient to protect the barrier plate from failure until the next mass production comes. Therefore, in terms of process, a lower rate of the evaporation and deposition is beneficial in placing a material of the second electron-blocking unit 1412 and a material of the first green light emitting unit 1422 in one chamber for evaporation and deposition, and sharing one mask. In comparison with related technologies that require two masks for manufacturing the second electron-blocking unit 1412 and the first green light emitting unit 1422, the technical solution of this application can use one less mask, thereby reducing the manufacturing costs of the display panel 100.

It should be noted that the Applicant of this application has found, through a large amount of practical experience, that in case that a certain material is evaporated and deposited by a vapor deposition machine, a barrier plate should be used to close gate(s) corresponding to the evaporation and deposition of other materials on the vapor deposition machine, so as to avoid evaporation and deposition of other materials onto a target substrate. In case that the barrier plate closes the gate, the evaporation and deposition process of other materials does not stop yet. Therefore, the other materials for evaporation and deposition accumulate on the barrier plate. In case that the other materials accumulate on the barrier plate to a certain extent, the barrier plate fails. Based on this, according to the present application, the thickness, overlapping with the first green light emitting unit 1422, of the second electron-blocking unit 1412 is reduced, which is beneficial in reducing the rate of evaporation and deposition of the material forming the second electron-blocking unit 1412. In case that the material of the second electron-blocking unit 1412 and the material of the first green light emitting unit 1422 are placed in one chamber for evaporation and deposition and share one mask to perform evaporation and deposition, a risk of failure of the barrier plate that blocks the material for evaporation and deposition of the second electron-blocking unit 1412 is reduced. It should also be noted that according to this application, the thickness of the second electron-blocking unit 1412 is a size of the second electron-blocking unit 1412 in a direction from the substrate 111 towards the light emitting device layer 12. Similarly, the thickness of the first electron-blocking unit 1411 is a size of the first electron-blocking unit 1411 in a direction from the substrate 111 towards the light emitting device layer 12. Other thicknesses mentioned in the following text are also a size in a direction from the substrate 111 towards the light emitting device layer 12.

Moreover, in related technologies, the first electron-blocking layer not only plays a role in blocking electrons, but also serves as a micro-cavity adjustment layer. Therefore, the thickness of the first electron-blocking layer can be adjusted by changing a size of the micro-cavity corresponding to the first light emitting layer 142. In order to obtain an optimal structural size of the micro-cavity corresponding to the first green light emitting unit so as to improve a light output efficiency of the first green light emitting unit, the thickness of the second electron-blocking unit is generally thicker.

In some embodiments, the first ratio may be greater than or equal to 0.5 and less than or equal to 1.8. Therefore, the second electron-blocking unit 1412 and the first green light emitting unit 1422 can be evaporated and deposited under one mask, so that the number of the masks required is reduced, the difficulty of monitoring the thickness of the second electron-blocking unit 1412 is lowered, the controllability of the thickness of the second electron-blocking unit 1412 is enhanced, and the effectiveness of the second electron-blocking unit 1412 is further ensured.

In some embodiments, the first ratio may be greater than or equal to 0.8 and less than or equal to 1.2. Therefore, the second electron-blocking unit 1412 and the first green light emitting unit 1422 can be evaporated and deposited under one mask, so that the number of the masks required is reduced, the difficulty of monitoring the thickness of the second electron-blocking unit 1412 is lowered, the controllability of the thickness of the second electron-blocking unit 1412 is enhanced, and the effectiveness of the second electron blocking unit 1412 is further ensured.

In some embodiments, the first ratio may be 1, where the thickness of the second electron-blocking unit 1412 is equal to the thickness of the first electron-blocking unit 1411. It should be noted that when the thickness of the second electron blocking unit 1412 is equal to that of the first electron blocking unit 1411, any thickness deviation therebetween within ±10% due to process limitations is also considered as thickness equality.

Optionally, the first ratio can be greater than or equal to 0.6 and less than or equal to 1.7, and the first ratio can also be greater than or equal to 0.7 and less than or equal to 1.5.

For example, the first ratio can be 0.5, 0.6, 0.7, 0.8, 0.9, 1.0, 1.1, 1.2, 1.3, 1.4, 1.5, 1.6, 1.7, 1.8, 1.9, or 1.95.

In some embodiments, the first electron-blocking layer 141 further includes a third electron-blocking unit 1413. The first light emitting layer 142 also includes a first red light emitting unit 1423. An orthographic projection of the first red light emitting unit 1423 on the substrate 111 overlaps with an orthographic projection of the third electron-blocking unit 1413 on the substrate 111. That is, the third electron-blocking unit 1413 plays a role in blocking electrons in the first red light emitting device of the first light emitting stack 14. The first red light emitting unit 1423 and the third electron-blocking unit 1413 are stacked and in direct contact with each other.

A ratio of a thickness of the third electron-blocking unit 1413 to the thickness of the first electron-blocking unit 1411 is a second ratio. A ratio of the second ratio to the first ratio is greater than or equal to 0.5 and less than or equal to 6. Therefore, the second ratio can be selected in a wide range, which enables the thickness of the third electron-blocking unit 1413 to be adjusted in a relative large range so that the different performance requirements of the display panel 100 can be met.

In some embodiments, the ratio of the second ratio to the first ratio may be greater than or equal to 0.8 and less than or equal to 5.5, greater than or equal to 1.2 and less than or equal to 5, greater than or equal to 1.5 and less than or equal to 4.5, greater than or equal to 2 and less than or equal to 4, or greater than or equal to 2.2 and less than or equal to 3.5.

For example, the ratio of the second ratio to the first ratio can be 0.5, 0.7, 0.9, 1, 1.5, 1.7, 2.0, 2.5, 2.7, 3.0, 3.5, 3.7, 4.0, 4.5, 4.7, 5.0, 5.5, 5.7, or 6.0.

In some embodiments, the second ratio is less than 4. Therefore, a thickness, overlapping with the first red light emitting unit 1423, of the third electron-blocking unit 1413 is relatively thinner, which is beneficial in reducing a rate of evaporation and deposition of a material forming the third electron-blocking unit 1413. Moreover, after the evaporation and deposition of the third electron-blocking unit 1413 is completed, the evaporation and deposition process of the material forming the third electron-blocking unit 1413 has not stop yet, and thus a material for the evaporation and deposition accumulates on the barrier plate that closes the gate. A lower rate of the evaporation and deposition is sufficient to protect the barrier plate from failure until the next mass production comes. Therefore, in terms of process, a lower rate of the evaporation and deposition is beneficial in for placing the material of the third electron-blocking unit 1413 and the material of the first red light emitting unit 1423 in one chamber for evaporation and deposition, and sharing one mask. In comparison with related technologies that requires two masks for manufacturing the third electron-blocking unit 1413 and the first red light emitting unit 1423, the technical solution of this application can use one less mask, thereby reducing the manufacturing costs of the display panel 100.

It should be noted that in comparison with related technologies, according to this application, the thickness of the third electron-blocking unit 1413 is thinned, so that one mask could be used for both the evaporation and deposition process of the third electron-blocking unit 1413 and the evaporation and deposition process of the first red light emitting unit 1423.

In some embodiments, the second ratio is greater than or equal to 0.8 and less than or equal to 1.2. Therefore, the third electron-blocking unit 1413 and the first red light emitting unit 1423 can be evaporated and deposited under one mask, so that the number of the masks required is reduced, the difficulty of monitoring the thickness of the third electron-blocking unit 1413 is lowered, the controllability of the thickness of the third electron-blocking unit 1413 is enhanced, and the effectiveness of the third electron-blocking unit 1413 is further ensured.

In some embodiments, the second ratio may be 1. That is, the thickness of the third electron-blocking unit 1413 is the same as the thickness of the first electron-blocking unit 1411. It should be noted that when the thickness of the third electron blocking unit 1413 is equal to that of the first electron blocking unit 1411, any thickness deviation therebetween within ±10% due to process limitations is also considered as thickness equality.

Optionally, the second ratio can be greater than or equal to 0.5 and less than or equal to 3.8, greater than or equal to 0.8 and less than or equal to 3.5, greater than or equal to 1.0 and less than or equal to 3.2, greater than or equal to 1.2 and less than 2.8, greater than or equal to 1.5 and less than or equal to 2.5, or greater than or equal to 1.8 and less than or equal to 2.2.

For example, the second ratio can be 0.5, 0.8, 1.0, 1.5, 1.8, 2.0, 2.5, 2.8, 3.0, 3.5, 3.8, or 4.0.

Based on the above content, it can be seen that according to the present application, the thicknesses of the second electron-blocking unit 1412 and the third electron-blocking unit 1413 of the first electron-blocking layer 141 are thinned so that the two masks required to form the first light emitting stack 14 is saved, thereby reducing the manufacturing costs of the display panel 100.

As shown in FIG. 1 to FIG. 3, in some embodiments, the first light emitting stack 14 further includes a first hole inject layer 143 (HIL), and the hole inject layer 143 is arranged between the anode layer 13 and the first electron-blocking layer 141.

As shown in FIG. 1 to FIG. 3, in some embodiments, the first light emitting stack 14 further includes a first hole transport layer 144 (HTL), and the first hole transport layer 144 is arranged between the hole inject layer 143 and the first electron-blocking layer 141.

As shown in FIG. 1 to FIG. 3, the charge generation layer 15 is arranged on a side, away from the first electron-blocking layer 141, of the first light emitting layer 142. The charge generation layer 15 includes a n-type charge generation layer 151. The n-type charge generation layer 151 is served as generating n-type charges.

In some embodiments, the n-type charge generation layer 151 includes a n-type semiconductor host material and a first doping material to increase the electron migration rate and enhance a balance of charge carriers. The n-type semiconductor host material includes but is not limited to at least one of pyridine derivatives, pyrimidine derivatives, triazine derivatives, imidazole derivatives, oxazole derivatives, and phenanthroline derivatives. The first doping material includes but is not limited to at least one of ytterbium (Yb), Li, Cs, and Mg. The electron mobility of the n-type charge generation layer 151 is µₑ, and µₑ ≥ 10⁻³cm²/Vs.

In some embodiments, the n-type semiconductor host material is selected from at least one compound as shown in the formula (1):

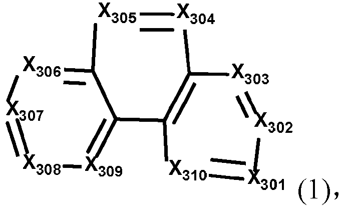

X301 to X309 are independently selected from C, N, pyridine groups or groups with pyridine derivatives, pyrimidine groups or groups with pyrimidine derivatives, triazine groups or groups with triazine derivatives, imidazole groups or groups with imidazole derivatives, oxazole groups or groups with oxazole derivatives, phenanthroline groups or groups with phenanthroline derivatives.

In some embodiments, the n-type semiconductor host material is selected from at least one of the following compounds:

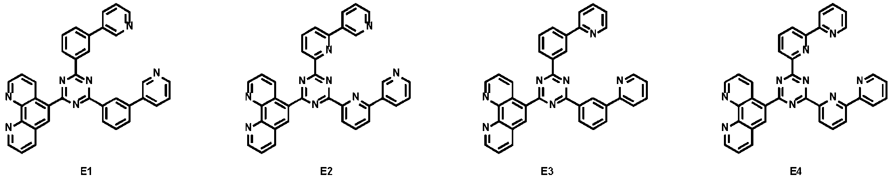

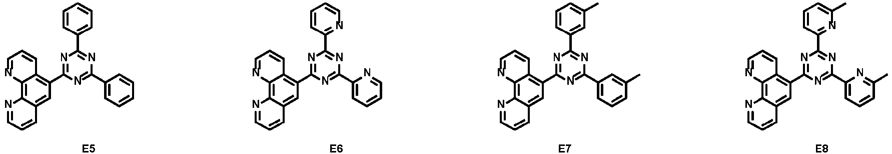

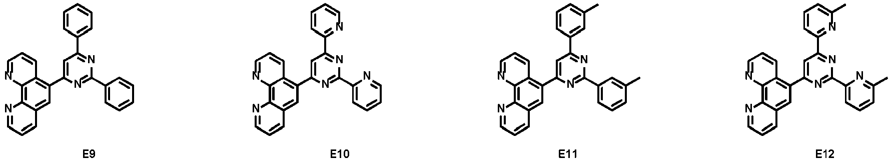

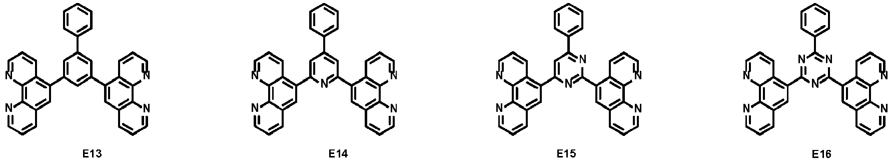

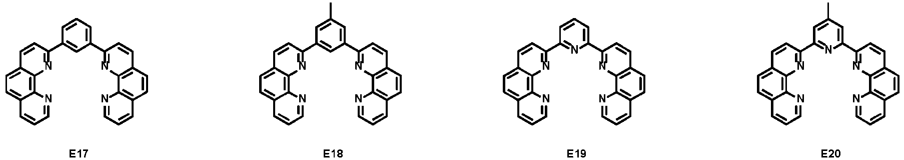

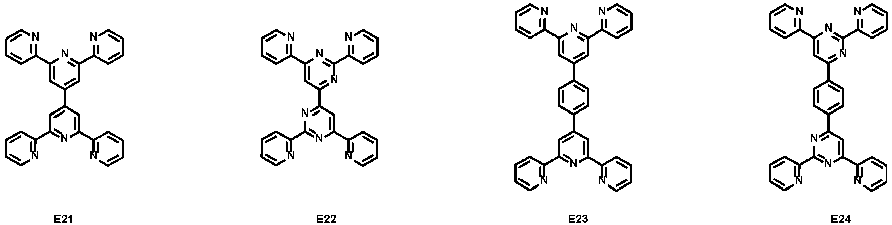

In some embodiments, a doping mass percentage of the first doping material is 5% to 15% to enhance the balance of charge carriers and improve the effect of thinning the thicknesses of the second electron-blocking unit 1412 and the third electron-blocking unit 1413 on the balance of charge carriers.

As shown in FIG. 1 to FIG. 3, in some embodiments, the display panel 100 further includes a first hole blocking layer 145 (HBL). The first hole blocking layer 145 is arranged between the n-type charge generation layer 151 and the first light emitting layer 142.

As shown in FIG. 1, in some embodiments, the display panel 100 further includes a first electron transport layer 146. The first electron transport layer 146 is arranged between the n-type charge generation layer 151 and the first hole blocking layer 145, and is in direct contact with the n-type charge generation layer 151 and the first hole blocking layer 145. Therefore, the stability of charge carrier transmission in the display panel 100 is ensured, thereby improving a display effect of the display panel 100.

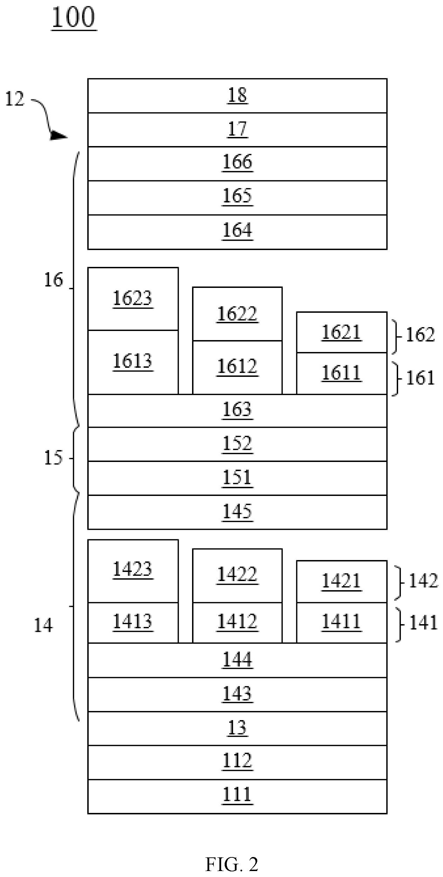

As shown in FIG. 2, in some embodiments, the display panel 100 further includes a first hole blocking layer 145 (HBL). The first hole blocking layer 145 is arranged between the n-type charge generation layer 151 and the first light emitting layer 142, and is in direct contact with the n-type charge generation layer 151. In this way, in comparison with the display panel 100 shown in FIG. 1, the first electron transport layer 146 in the first light emitting stack 14 is removed from the display panel 100, so that the mask that forms the first electron transport layer 146 is eliminated, thereby further reducing the manufacturing costs of the display panel 100. Moreover, in comparison with removing other film layers in the first and second light emitting stacks 14 and 16 (such as a film layer in the second light emitting stack 16 or other film layers in the first light emitting stack 14), removing the first electron transport layer 146 is removed can minimizes negative impact on driving voltage, light emitting efficiency, and service lifespan, that is, it minimizes the negative impact on the display panel 100.

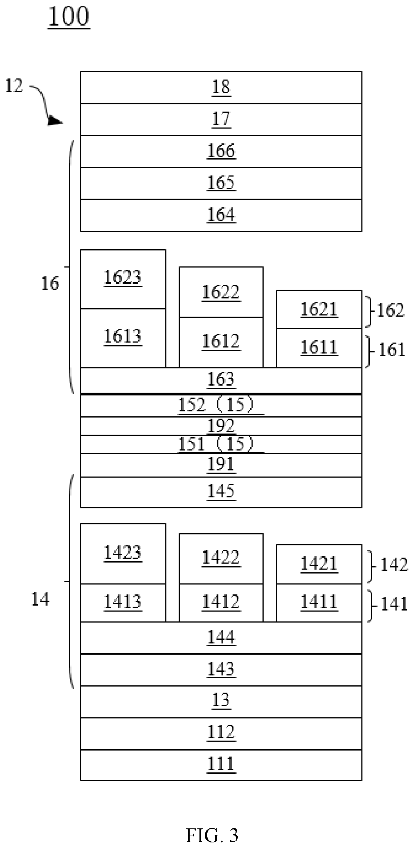

As shown in FIG. 3, in some embodiments, the display panel 100 further includes a first intermediate transport layer 191. The first intermediate transport layer 191 is arranged between the first hole blocking layer 145 and the n-type charge generation layer 151, is in direct contact with the n-type charge generation layer 151 and the first hole blocking layer 145, and includes a n-type semiconductor host material. Thus, the first intermediate transport layer 191 is added instead of the first electron transport layer 146. The first intermediate transport layer 191 includes a n-type semiconductor host material with electron transport capability, enabling it to replace the first electron transport layer 146 in transporting electrons and ensure the performance of the display panel 100. Moreover, a material of the first intermediate transport layer 191 includes the n-type semiconductor host material of the n-type charge generation layer 151. The angle plate used to form the n-type charge generation layer 151 can be adjusted so that the n-type semiconductor host material and the first dopant material are not fully coevaporated and co-deposited without increasing the number of scans, thereby forming the first intermediate transport layer 191. That is, the first intermediate transport layer 191 is formed using the process of evaporation and deposition and the mask for forming the n-type charge generation layer 151, without the need to add additional masks. Therefore, the masks for forming the first electron transport layer 146 are saved while the performance of the display panel 100 is improved.

As shown in FIG. 1 to FIG. 3, the second light emitting stack 16 is arranged on a side, away from the first light emitting layer 142, of the charge generation layer 15. The cathode layer 17 is arranged on a side, away from the substrate 111, of the second light emitting stack 16. The second light emitting stack 16 also includes a second hole blocking layer 164 and a second electron transport layer 165. The second hole blocking layer 164 plays a role in blocking holes in the second light emitting stack 16. The second electron transport layer 165 plays a role in transporting electrons in the second light emitting stack 16.

In some embodiments, the second hole blocking layer 164 is arranged between a second light emitting layer 162 and the cathode layer 17. The second electron transport layer 165 is arranged between the second hole blocking layer 164 and the cathode layer 17. A ratio of a thickness of the first intermediate transport layer 191 to the second electron transport layer 165 is greater than or equal to 0.05 and less than or equal to 0.15. Therefore, while ensuring the transport performance of the first intermediate transport layer 191, the difficulty of adjusting the angle plate forming the n-type charge generation layer 151 so as to form the first intermediate transport layer 191 is reduced.

Optionally, the ratio of the thickness of the first intermediate transport layer 191 to the second electron transport layer 165 is greater than or equal to 0.08 and less than or equal to 0.14, or greater than or equal to 0.1 and less than or equal to 0.12.

For example, the ratio of the thickness of the first intermediate transport layer 191 to the second electron transport layer 165 is 0.05, 0.06, 0.07, 0.08, 0.09, 0.1, 0.11, 0.12, 0.13, 0.14, or 0.15.

As shown in FIG. 1 to FIG. 3, the charge generation layer 15 also includes a p-type charge generation layer 152. The p-type charge generation layer 152 is served as generating p-type charges.

The p-type charge generation layer 152 includes a p-type semiconductor host material and a second doping material to increase the hole migration rate and enhance the balance of the charge carriers. The second doping material includes metals or metal dopants. The p-type semiconductor host material is generally composed of metal oxides (such as ITO, WO₃, MoO₃, V₂O₅) or Lewis acids doped with hole transport materials (such as FeCl₃: NPB, F4-TCNQ: NPB).

In some embodiments, the n-type charge generation layer 151 is arranged between the p-type charge generation layer 152 and the first light emitting layer 142. The display panel 100 also includes a second intermediate transport layer 192. The second intermediate transport layer 192 is arranged between the p-type charge generation layer 152 and the n-type charge generation layer 151, and includes a n-type semiconductor host material. Therefore, the second intermediate transport layer 192 is arranged between the n-type charge generation layer 151 and the p-type charge generation layer 152 to further enhance the balance of the charge carriers. Moreover, a material of the second intermediate transport layer 192 includes the n-type semiconductor host material of the n-type charge generation layer 151, so that the second intermediate transport layer 192 is formed by adjusting an angle plate for forming the n-type charge generation layer 151. That is, the second intermediate transport layer 192 can be formed using the evaporation and deposition process and the mask for forming the n-type charge generation layer 151, without the need for additional masks. Therefore, the performance of the display panel 100 can be improved without increasing the number of the mask.

In some embodiments, a ratio of a thickness of the second intermediate transport layer 192 to the second electron transport layer 165 is greater than or equal to 0.05 and less than or equal to 0.15. Therefore, the transport performance of the second intermediate transport layer 192 is ensured, and the process difficulty of forming the second intermediate transport layer 192 by adjusting the angle plate for forming the n-type charge generation layer 151 is reduced at the same time.

Optionally, the ratio of the thickness of the second intermediate transport layer 192 to the second electron transport layer 165 is greater than or equal to 0.08 and less than or equal to 0.14, or greater than or equal to 0.1 and less than or equal to 0.12.

For example, the ratio of the thickness of the second intermediate transport layer 192 to the second electron transport layer 165 is 0.05, 0.06, 0.07, 0.08, 0.09, 0.1, 0.11, 0.12, 0.13, 0.14, or 0.15.

As shown in FIG. 1 to Fig. 3, the second light emitting stack 16 includes a second light emitting layer 162, and the second light emitting layer 162 is arranged on a side, away from the first light emitting layer 142, of the charge generation layer 15. The second light emitting layer 162 includes a second blue light emitting unit 1621 and a second green light emitting unit 1622.

As shown in FIG. 1 to FIG. 3, the second light emitting stack 16 also includes a second electron-blocking layer 161. The second electron-blocking layer 161 is arranged between the charge generation layer 15 and the second light emitting layer 162. The second electron-blocking layer 161 plays a role in blocking electrons. The second electron-blocking layer 161 includes a fourth electron-blocking unit 1611 and a fifth electron-blocking unit 1612.

An orthographic projection of the second blue light emitting unit 1621 on the substrate 111 overlaps with orthographic projections of the first blue light emitting unit 1421 and the fourth electron-blocking unit 1611 on the substrate 111. The second blue light emitting unit 1621 is stacked and in direct contact with the fourth electron-blocking unit 1611. The first blue light emitting unit 1421 is stacked with the second blue light emitting unit 1621, and the fourth electron-blocking unit 1611 plays a role in blocking electrons in the second blue light emitting device.

An orthographic projection of the second green light emitting unit 1622 on the substrate 111 overlaps with orthographic projections of the first green light emitting unit 1422 and the fifth electron-blocking unit 1612 on the substrate 111. The second green light emitting unit 1622 is stacked and in direct contact with the fifth electron-blocking unit 1612. The first green light emitting unit 1422 is stacked with the second green light emitting unit 1622, and the fifth electron-blocking unit 1612 plays a role in blocking electrons in the second green light emitting device.

In some embodiments, a ratio of a thickness of the fifth electron-blocking unit 1612 to a thickness of the fourth electron-blocking unit 1611 is a third ratio, and the third ratio is greater than the first ratio. Therefore, the ratio of the thickness of the fifth electron-blocking unit 1612 to the thickness of the fourth electron-blocking unit 1611 is relatively larger. The thickness of the fifth electron-blocking unit 1612 is increased so as to compensate for the thinned thickness of the second electron-blocking unit 1412, reduce the negative impact of the thinned thickness on the optimal micro-cavity size corresponding to the second green light emitting device, and thereby the light output efficiency of light emitted by the second green light emitting unit 1622 is improved.

It should be noted that the optimal micro-cavity size corresponding to each light emitting unit in the second light emitting layer 162 is related to the thickness of all film layers between the anode layer 13 and the cathode layer 17. Moreover, the second light emitting layer 16 is arranged at a top of the light emitting device layer 12, and a light output efficiency of the second light emitting stack 16 is higher than a light output efficiency of the first light emitting stack 14. A micro-cavity structure design enhances the light output efficiency of the light emitted by the second green light emitting unit 1622 in the second light emitting stack 16, which can further the display effect of the display panel 100. In addition, as the wavelengths of blue light, green light, and red light are progressively increased, a size of the micro-cavity structures corresponding to blue light, green light, and red light also shows a progressive increasing trend.

In some embodiments, a ratio of the third ratio to the first ratio is greater than or equal to 4.5 and less than or equal to 6.5. Therefore, the thickness of the fifth electron-blocking unit 1612 is increased so that the micro-cavity corresponding to the second green light emitting device has a size within an appropriate range, thereby maximizing the light output efficiency of the light emitted by the green light emitted by the second green light emitting unit 1622.

Optionally, the ratio of the third ratio to the first ratio is greater than or equal to 4.8 and less than or equal to 6, greater than or equal to 5 and less than or equal to 5.8, or greater than or equal to 5.2 and less than or equal to 5.6.

For example, the ratio of the third ratio to the first ratio is 4.5, 4.7, 4.9, 5.1, 5.3, 5.5, 5.7, 5.9, or 6.0.

In some embodiments, the third ratio is greater than or equal to 5 and less than or equal to 6. Therefore, the ratio of the thickness of the fifth electron-blocking unit 1612 to the thickness of the fourth electron-blocking unit 1611 is within an appropriate range. Therefore, the thickness of the fifth electron-blocking unit 1612 is increased so that the micro-cavity corresponding to the second green light emitting device has a size within an appropriate range, thereby maximizing the light output efficiency of the green light emitted by the second green light emitting unit 1622.

For example, the third ratio is 5, 5.1, 5.2, 5.3, 5.4, 5.5, 5.6, 5.7, 5.8, 5.9, or 6.0.

In some embodiments, the thickness of the fifth electron-blocking unit 1612 is greater than the thickness of the fourth electron-blocking unit 1611 and the thickness of the second electron-blocking unit 1412. In this way, the thickness of the fifth electron-blocking unit 1612 is increased so that the reduced size of the micro-cavity structure corresponding to the second green light emitting device due to the thinned thickness of the second electron-blocking unit 1412 is compensated, thereby improving the light output efficiency of the light emitted by the second green light emitting unit 1622.

In some embodiments, a ratio of the thickness of the fourth electron-blocking unit 1611 to the thickness of the first electron-blocking unit 1411 is a fourth ratio, and the fourth ratio is greater than or equal to 0.8 and less than or equal to 1.2. In this way, the thickness of the fourth electron-blocking unit 1611 becomes to be the equal as the thickness of the first electron-blocking unit 1411, so that the fourth electron-blocking unit 1611 and the first electron-blocking unit 1411 are formed through the same process, thereby simplifying the manufacturing process of the display panel 100.

In some embodiments, the thickness of the fourth electron-blocking unit 1611 is equal to the thickness of the first electron-blocking unit 1411.

In some embodiments, it is required that the thicknesses of both the fourth electron-blocking unit 1611 and the first electron-blocking unit 1411 are greater than 0Å and less than or equal to 200Å.

In some embodiments, the materials of the fourth electron-blocking unit 1611 and the first electron-blocking unit 1411 include aromatic amine compounds. The aromatic amine compounds are auxiliary hole transport materials, also known as electron-blocking layer materials.

In some embodiments, HOMO energy levels of the fourth electron-blocking unit 1611 and the first electron-blocking unit 1411 are 0-0.5 eV deeper than HOMO energy levels of the first hole transport layer 144 and a second hole transport layer 163.

As shown in FIG. 1 to FIG. 3, the second electron-blocking layer 161 also includes a sixth electron-blocking unit 1613. The second light emitting layer 162 also includes a second red light emitting unit 1623. An orthographic projection of the second red light emitting unit 1623 on the substrate 111 overlaps with an orthographic projection of the sixth electron-blocking unit 1613 and the orthographic projection of the first red light emitting unit 1423 on the substrate 111. The second red light emitting unit 1623 is stacked and in direct contact with the sixth electron-blocking unit 1613. The second red light emitting unit 1623 is stacked with the first red light emitting unit 1423.

In some embodiments, a ratio of a thickness of the sixth electron-blocking unit 1613 to a thickness of the fourth electron-blocking unit 1611 is a fifth ratio, and the fifth ratio is greater than the third ratio. Therefore, the ratio of the thickness of the sixth electron-blocking unit 1613 to the thickness of the fourth electron-blocking unit 1611 is relatively larger. The thickness of the sixth electron-blocking unit 1613 is increased so as to compensate for the reduced size of the micro-cavity structure corresponding to the second red light emitting device due to the thinned thickness of the third electron-blocking unit 1413, thereby improving the light output efficiency of the light emitted by the second red light emitting unit 1623.

In some embodiments, a ratio of the fifth ratio to the third ratio is greater than or equal to 2 and less than or equal to 3. Therefore, the increased value in the thickness of the sixth electron-blocking unit 1613 is greater than the increased value in the thickness of the fifth electron-blocking unit 1612, so as to compensate for the reduced size of the micro-cavity structure corresponding to the second red light emitting device due to the thinned thickness of the third electron-blocking unit 1413 in a better way, and thereby improve the light output efficiency of the light emitted by the second red light emitting unit 1623.

In some embodiments, the fifth ratio is greater than the second ratio. Therefore, in case that the thickness of the third electron-blocking unit 1413 becomes to be equal to the thickness of the first electron-blocking unit 1411, the difference in thickness between the sixth electron-blocking unit 1613 and the fourth electron-blocking unit 1611 is a lot greater. The thickness of the sixth electron-blocking unit 1613 is increased so as to compensate for the reduced size of the micro-cavity structure corresponding to the second red light emitting device due to the thinned thickness of the third electron-blocking unit 1413, thereby improving the light output efficiency of the light emitted by the second red light emitting unit 1623.

In some embodiments, a ratio of the fifth ratio to the second ratio is greater than or equal to 10 and less than or equal to 15. Therefore, the thickness of the sixth electron-blocking unit 1613 is increased so as to compensate for the reduced size of the micro-cavity structure corresponding to the second red light emitting device due to the thinned thickness of the third electron-blocking unit 1413, thereby improving the light output efficiency of the light emitted by the second red light emitting unit 1623.

In some embodiments, the fifth ratio is greater than or equal to 10 and less than or equal to 15. Therefore, the thickness of the sixth electron-blocking unit 1613 is increased so as to compensate for the reduced size of the micro-cavity structure corresponding to the second red light emitting device due to the thinned thickness of the third electron-blocking unit 1413.

Optionally, the fifth ratio is greater than or equal to 10.5 and less than or equal to 14.5, greater than or equal to 11.5 and less than or equal to 13.5, or greater than or equal to 12.5 and less than or equal to 14.5.

For example, the fifth ratio is 10.5, 11, 11.5, 12, 12.5, 13, 13.5, 14, 14.5, or 15.

In some embodiments, the thickness of the sixth electron-blocking unit 1613 is greater than the thickness of the third electron-blocking unit 1413.

As shown in FIG. 1 to FIG. 3, the second light emitting stack 16 also includes a second hole transport layer 163, and the second hole transport layer 163 is arranged between the charge generation layer 15 and the second electron-blocking layer 161.

As shown in FIG. 1 to FIG. 3, the second light emitting stack 16 also includes an electron inject layer 166, and the electron inject layer 166 is arranged between the cathode layer 17 and the second electron transport layer 165.

Based on the above, it can be seen that, according to some embodiments of the present application, besides the thinned thicknesses of the second electron-blocking unit 1412 and the third electron-blocking unit 1413 of the first electron-blocking layer 141, the thicknesses of the fifth electron-blocking unit 1612 and the sixth electron-blocking unit 1613 of the second electron-blocking layer 161 are enlarged so as to compensate for the reduced thickness of the micro-cavity structure, improve the overall light output efficiency of the second light emitting layer 162, and enhance the display brightness of the display panel 100. Moreover, the thicknesses of the fifth electron-blocking unit 1612 and the sixth electron-blocking unit 1613 in the second electron-blocking layer 161 are increased, so that a path for electrons to pass through the second electron-blocking layer 161 is extended, the probability of electrons entering the second hole transport layer 163 in the second light emitting stack 16 is reduced, the lifespan of the second hole transport layer 163 is prolonged, and thus the service life of the display panel 100 is prolonged. In addition, since the holes have a migration rate higher than that of the electron, thickening of the second electron-blocking layer 161 extends a path for holes to enter the second light emitting layer 162 and stabilizes the balance of the charge carriers.

In some embodiments, a mass percentage of the second doping material in the p-type charge transport layer is 1% to 10%, so that the hole migration rate is reduced and the balance of the charge carriers is enhanced.

In some embodiments, the materials of the second electron-blocking unit 1412 and the fifth electron-blocking unit 1612 include but are not limited to aromatic amine compounds. The aromatic amine compounds are auxiliary hole transport materials, also known as electron-blocking layer materials. HOMO energy levels of the second electron-blocking unit 1412 and the fifth electron-blocking unit 1612 are 0-0.5eV deeper than HOMO energy levels of the first hole transport layer 144 and the second hole transport layer 163.

In some embodiments, the materials of the third electron-blocking unit 1413 and the sixth electron-blocking unit 1613 include but are not limited to aromatic amine compounds. The aromatic amine compounds are auxiliary hole transport materials, also known as electron-blocking layer materials. HOMO energy levels of the third electron-blocking unit 1413 and the sixth electron-blocking unit 1613 are 0-0.5eV deeper than HOMO energy levels of the first hole transport layer 144 and the second hole transport layer 163.

In some embodiments, a difference between a HOMO energy level of either the first electron-blocking unit 1411 or the fourth electron-blocking unit 1611 and a HOMO energy level of either the second electron-blocking unit 1412 or the fifth electron-blocking unit 1612 is greater than or equal to 0eV and less than or equal to 0.1eV. A difference between a LUMO energy level of either the second electron-blocking unit 1412 or the fifth electron-blocking unit 1612 and a LUMO energy level of either the first electron-blocking unit 1411 or the fourth electron-blocking unit 1611 is greater than or equal to 0eV and less than or equal to 0.1eV.

In some embodiments, a difference between a HOMO energy level of either the first electron-blocking unit 1411 or the fourth electron-blocking unit 1611 and a HOMO energy level of either the first hole transport layer 144 or the second hole transport layer 163 is greater than or equal to 0eV and less than or equal to 0.1eV.

In some embodiments, a difference between a HOMO energy level of either the first green light emitting unit 1422 or the second green light emitting unit 1622 and a HOMO energy level of either the first electron-blocking unit 1411 or the fourth electron-blocking unit 1611 is greater than or equal to 0.1eV and less than or equal to 0.2eV.

In some embodiments, a difference between a HOMO energy level of either the first red light emitting unit 1423 or the second red light emitting unit 1623 and a HOMO energy level of either the first electron-blocking unit 1411 or the fourth electron-blocking unit 1611 is greater than or equal to 0.1eV and less than or equal to 0.2eV.

The cathode layer 17 is arranged on a side, away from the charge generation layer 15, of the second light emitting layer 162. Specifically, the cathode layer 17 is arranged on a side, away from the substrate 111, of the second light emitting stack 16. The cathode layer 17 includes metal materials such as magnesium and silver.

As shown in FIG. 1 to FIG. 3, the display panel 100 further includes a driving circuit layer 112, and the driving circuit layer 112 is arranged between the substrate 111 and the light emitting device layer 12. The driving circuit layer 112 includes pixel driving circuits.

As shown in FIG. 1 to FIG. 3, the display panel 100 may further include a cover layer 18, and the cover layer 18 is arranged on a side, away from the substrate 111, of the cathode layer 17. The refractive index of the cover layer 18 is greater than the refractive index of the cathode layer 17 to further improve the light output efficiency of the display panel 100.

The display panel 100 may also include a thin film encapsulation layer arranged on a side, away from the substrate 111, of the cover layer 18.

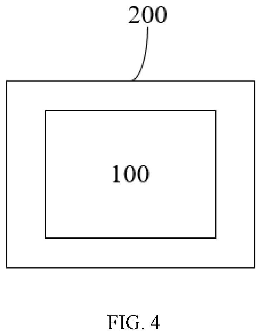

As shown in FIG. 4, based on a same inventive concept, the present application also provides a display device 200, and the display device 200 includes the display panel 100 of any of the above embodiments.

The above embodiments are only used to help understand the technical solutions and core idea of the present application. Ordinary skills in the art should understand that they can still modify the technical solutions described in the aforementioned embodiments, or equivalently substitute some of the technical features. These modifications or substitutions do not deviate from the essence of the corresponding technical solutions from the scope of the technical solutions of the various embodiments of the present application.

## Claims

1. A display panel, comprising:
a substrate; and
a light emitting device layer arranged on a side of the substrate and comprising:
an anode layer arranged on a side of the substrate;
a first electron-blocking layer arranged on a side, away from the substrate, of the anode layer, and comprising a first electron-blocking unit and a second electron-blocking unit; wherein a ratio of a thickness of the second electron-blocking unit to a thickness of the first electron-blocking unit is a first ratio, and the first ratio is less than 2;
a first light emitting layer arranged on a side, away from the anode layer, of the first electron-blocking layer, and comprising a first blue light emitting unit and a first green light emitting unit; wherein an orthographic projection of the first blue light emitting unit on the substrate overlaps with an orthographic projection of the first electron-blocking unit on the substrate, and an orthographic projection of the first green light emitting unit on the substrate overlaps with an orthographic projection of the second electron-blocking unit on the substrate;
a charge generation layer arranged on a side, away from the first electron-blocking layer, of the first light emitting layer;
a second light emitting layer arranged on a side, away from the first light emitting layer, of the charge generation layer; and
a cathode layer arranged on a side, away from the charge generation layer, of the second light emitting layer.

2. The display panel according to claim 1, wherein the first ratio is greater than or equal to 0.8 and less than or equal to 1.2.

3. The display panel according to claim 1, wherein the first electron-blocking layer further comprises a third electron-blocking unit, the first light emitting layer further comprises a first red light emitting unit, and an orthographic projection of the first red light emitting unit on the substrate overlaps with an orthographic projection of the third electron-blocking unit on the substrate;
wherein, a ratio of a thickness of the third electron-blocking unit to the thickness of the first electron-blocking unit is a second ratio, and a ratio of the second ratio to the first ratio is greater than or equal to 0.5 and less than or equal to 6.

4. The display panel according to claim 3, wherein the second ratio is greater than or equal to 0.8 and less than or equal to 1.2.

5. The display panel according to claim 1, wherein the display panel further comprises a second electron-blocking layer arranged between the charge generation layer and the second light emitting layer, and comprises a fourth electron-blocking unit and a fifth electron-blocking unit;
the second light emitting layer comprises a second blue light emitting unit and a second green light emitting unit; an orthographic projection of the second blue light emitting unit on the substrate overlaps with orthographic projections of the first blue light emitting unit and the fourth electron-blocking unit on the substrate, an orthographic projection of the second green light emitting unit on the substrate overlaps with orthographic projections of the first green light emitting unit and the fifth electron-blocking unit on the substrate;
wherein, a ratio of a thickness of the fifth electron-blocking unit to a thickness of the fourth electron-blocking unit is a third ratio, and the third ratio is greater than the first ratio.

6. The display panel according to claim 5, wherein a ratio of the third ratio to the first ratio is greater than or equal to 4.5 and less than or equal to 6.5.

7. The display panel according to claim 5, wherein the thickness of the fifth electron-blocking unit is greater than the thickness of the fourth electron-blocking unit and the thickness of the second electron-blocking unit.

8. The display panel according to claim 5, wherein the third ratio is greater than or equal to 5 and less than or equal to 6.

9. The display panel according to claim 5, wherein a ratio of the thickness of the fourth electron-blocking unit to the thickness of the first electron-blocking unit is a fourth ratio, and the fourth ratio is greater than or equal to 0.8 and less than or equal to 1.2.

10. The display panel according to claim 5, wherein the first electron-blocking layer further comprises a third electron-blocking unit, the first light emitting layer further comprises a first red light emitting unit, and an orthographic projection of the first red light emitting unit on the substrate overlaps with an orthographic projection of the third electron-blocking unit on the substrate;
the second electron-blocking layer further comprises a sixth electron-blocking unit, the second light emitting layer further comprises a second red light emitting unit, and an orthographic projection of the second light emitting unit on the substrate overlaps with orthographic projections of the sixth electron-blocking unit and the first red light emitting unit on the substrate;
wherein, a ratio of a thickness of the sixth electron-blocking unit to a thickness of the fourth electron-blocking unit is a fifth ratio, and the fifth ratio is greater than the third ratio.

11. The display panel according to claim 10, **characterized in that** a ratio of the fifth ratio to the third ratio is greater than or equal to 2 and less than or equal to 3.

12. The display panel according to claim 10, **characterized in that** a ratio of the thickness of the third electron-blocking unit to the thickness of the first electron-blocking unit is a second ratio, and the fifth ratio is greater than the second ratio.

13. The display panel according to claim 10, **characterized in that** the fifth ratio is greater than or equal to 10 and less than or equal to 15.

14. The display panel according to claim 1, wherein the charge generation layer comprises a n-type charge generation layer;
the display panel further comprises a first hole blocking layer, the first hole blocking layer is arranged between the n-type charge generation layer and the first light emitting layer, and is in direct contact with the n-type charge generation layer.

15. The display panel according to claim 1, **characterized in that** the charge generation layer comprises a n-type charge generation layer;
the display panel further comprises a first hole blocking layer and a first electron transport layer, the first hole blocking layer is arranged between the n-type charge generation layer and the first light emitting layer, the first electron transport layer is arranged between the n-type charge generation layer and the first hole blocking layer, and is in direct contact with the n-type charge generation layer and the first hole blocking layer.

16. The display panel according to claim 1, wherein the charge generation layer comprises a n-type charge generation layer, and the n-type charge generation layer comprises a n-type semiconductor host material;
the display panel further comprises:
a first hole blocking layer arranged between the n-type charge generation layer and the first light emitting layer; and
a first intermediate transport layer arranged between the first hole blocking layer and the n-type charge generation layer, in direct contact with the n-type charge generation layer, and comprising the n-type semiconductor host material.

17. The display panel according to claim 16, wherein the display panel further comprises:
a second hole blocking layer arranged between the second light emitting layer and the cathode layer; and
a second electron transport layer arranged between the second hole blocking layer and the cathode layer;
wherein, a ratio of a thickness of the first intermediate transport layer to the second electron transport layer is greater than or equal to 0.05 and less than or equal to 0.15.

18. The display panel according to claim 1, wherein the charge generation layer further comprises a n-type charge generation layer and a p-type charge generation layer, the n-type charge generation layer is arranged between the p-type charge generation layer and the first light emitting layer, and the n-type charge generation layer comprises a n-type semiconductor host material;
the display panel further comprises:
a second intermediate transport layer arranged between the p-type charge generation layer and the n-type charge generation layer, and comprising the n-type semiconductor host material.

19. A display device, wherein the display device comprises a display panel, the display panel comprises:
a substrate; and
a light emitting device layer arranged on a side of the substrate and comprising:
an anode layer arranged on a side of the substrate;
a first electron-blocking layer arranged on a side, away from the substrate, of the anode layer, and comprising a first electron-blocking unit and a second electron-blocking unit; wherein a ratio of a thickness of the second electron-blocking unit to a thickness of the first electron-blocking unit is a first ratio, and the first ratio is less than 2;
a first light emitting layer arranged on a side, away from the anode layer, of the first electron-blocking layer, and comprising a first blue light emitting unit and a first green light emitting unit; wherein an orthographic projection of the first blue light emitting unit on the substrate overlaps with an orthographic projection of the first electron-blocking unit on the substrate, and an orthographic projection of the first green light emitting unit on the substrate overlaps with an orthographic projection of the second electron-blocking unit on the substrate;
a charge generation layer arranged on a side, away from the first electron-blocking layer, of the first light emitting layer;
a second light emitting layer arranged on a side, away from the first light emitting layer, of the charge generation layer; and
a cathode layer arranged on a side, away from the charge generation layer, of the second light emitting layer.

20. The display device according to claim 19, wherein the first ratio is greater than or equal to 0.8 and less than or equal to 1.2.
